# EUROPEAN PATENT APPLICATION

(11) **EP 4 794 475 A1**
(43) Date of publication of application: **19.08.2026**
(21) Application number: 25206132.0
(22) Date of filing: 01.10.2025
(51) Int. Cl.: H10D 62/17, H10D 30/63, H10D 62/40, H10D 62/822, H10D 62/832

(54) **SEMICONDUCTOR DEVICE**

(30) Priority: 12.02.2025 KR 20250018309
(71) Applicant: Samsung Electronics Co., Ltd., Suwon-si, Gyeonggi-do 16677 (KR)
(72) Inventor: KIM, Taehun, Suwon-si (KR); KIL, Taehyeon, Suwon-si (KR); PARK, Young Hwan, Suwon-si (KR); PARK, Jeonghwan, Suwon-si (KR); OH, Sewoong, Suwon-si (KR); YUN, Jeongeun, Suwon-si (KR)
(74) Representative: Marks & Clerk LLP

(57) **Abstract**

A semiconductor device comprising: a substrate (110) includes a first surface (110a) and a second surface (110b) opposing each other; an epitaxial layer (131) positioned on the first surface (110a) of the substrate (110), including a gate trench (160), and the epitaxial layer (131) having a first conductivity type; a channel layer (300) positioned on the inner sidewall (160_s) of the gate trench (160) and having the first conductivity type; a gate electrode (150) positioned on the inner side surface of the channel layer (300); a gate insulating layer (140) positioned on the bottom surface of the gate trench (160), and between the channel layer (300) and the gate electrode (150); a source electrode (173) positioned on the epitaxial layer (131); and a drain electrode (175) positioned on the second surface (110b) of the substrate (110).

## Description

### BACKGROUND

The present disclosure relates to a semiconductor device.

In general, semiconductor devices are closely related to our daily lives. In particular, power semiconductor devices are becoming increasingly important in various fields, such as the transportation field, for example, electric vehicles, trains, and electric trams, renewable energy systems, for example, solar power generation and wind power generation, and mobile devices. Power semiconductor devices are semiconductor devices usable to handle high voltage or high current, and perform functions such as power conversion and control in large power systems and high-power electronic devices. Power semiconductor devices have the ability and durability to handle high power, allowing them to handle large amounts of current and withstand high voltages. For example, power semiconductor devices can handle voltages of hundreds to thousands of volts and currents of tens to thousands of amperes. Power semiconductor devices can improve the efficiency of electrical energy by reducing power losses. Further, power semiconductor devices can be stably driven in environments such as high temperatures.

### SUMMARY

Power semiconductor devices can be categorized by their materials, such as SiC power semiconductor devices and GaN power semiconductor devices. Instead of silicon (Si) wafers, SiC or GaN may be used to manufacture power semiconductor devices, whereby it is possible to compensate for the disadvantages of silicon having unstable characteristics at high temperatures. SiC power semiconductor devices are resistant to high temperatures and have low power loss, making them suitable for electric vehicles, renewable energy systems, and the like. GaN power semiconductor devices require high costs, but are efficient in terms of speed, making them suitable for fast charging of mobile devices and the like. Aspects of the disclosed implementations provide a semiconductor device with stable electric characteristics and improved reliability.

According to some implementations, a semiconductor device comprising: a substrate including a first surface and a second surface that is on an opposite side of the substrate form the first surface; an epitaxial layer on the first surface of the substrate, the epitaxial layer including a gate trench, wherein the epitaxial layer has a first conductivity type; a channel layer on an inner sidewall of the gate trench wherein the channel layer has the first conductivity type and has a lower defect rate than that of the epitaxial layer; a gate electrode in the gate trench; a gate insulating layer on a bottom surface of the gate trench, and between the channel layer and the gate electrode; a source electrode on the epitaxial layer; and a drain electrode on the second surface of the substrate.

According to some implementations, a semiconductor device comprising: a substrate including a first surface and a second surface, where the first surface is on an opposite side of the substrate from the second surface; an epitaxial layer on the first surface of the substrate, the epitaxial layer including a gate trench, where the epitaxial layer has a first conductivity type; a well region on the epitaxial layer and having a second conductivity type different from the first conductivity type; a channel layer having the first conductivity type, on an inner sidewall of the gate trench, where the channel layer has a lower defect rate than that of the epitaxial layer; a gate electrode within the gate trench, where the gate electrode extends in a first direction; a gate insulating layer between the channel layer and the gate electrode; a source electrode on the well region; and a drain electrode on the second surface of the substrate, wherein the channel layer extends in the first direction and protrudes from a lower surface of the well region toward the first surface of the substrate.

According to some implementations, a semiconductor device comprising: a substrate including a first surface and a second surface wherein the first surface is on an opposite side of the substrate from the second surface, an epitaxial layer on the first surface of the substrate, including a gate trench, and including 4H-SiC; a channel layer including 3C-SiC, wherein the channel layer is on an inner sidewall of the gate trench, and wherein the channel layer has a lower defect rate than that of the epitaxial layer; a gate electrode in the trench; a gate insulating layer between the channel layer and the gate electrode; a source electrode on the epitaxial layer, and a drain electrode on the second surface of the substrate.

A method for manufacturing a semiconductor device according to some implementations includes the steps of forming an epitaxial layer having a first conductivity type on a first surface of a substrate, forming a gate trench in the epitaxial layer, forming a channel material layer having the first conductivity type in the gate trench, patterning the channel material layer to form a channel layer exposing a bottom surface of the gate trench, forming a gate insulating layer on an inner side surface of the channel layer and a bottom surface of the gate trench, forming a gate electrode on the gate insulating layer, and forming a source electrode on the epitaxial layer and a drain electrode on a second surface of the substrate opposite to the first surface.

The channel layer may include the same material as the epitaxial layer.

The channel layer may have a different crystal structure than the epitaxial layer.

The channel layer may include a first material and a second material different from the first material, wherein the first material may include Si and the second material may include C.

The lower surface of the gate insulating layer may be in contact with the epitaxial layer.

A distance between the lower surface of the gate insulating layer and the first surface of the substrate may be equal to a distance between the lower surface of the channel layer and the first surface of the substrate.

A thickness of the channel layer may be 1/10 to 1/3 of a width of the gate trench. The channel layer may include a portion whose thickness increases with distance from the bottom surface of the gate trench.

The step of forming the channel layer may include removing at least a portion of the channel material layer by a dry etching method.

The step of forming the epitaxial layer may further include a step of forming a well region having a second conductivity type different from the first conductivity type within the epitaxial layer.

The channel layer may protrude from the lower surface of the well region toward the first surface of the substrate.

The channel layer may overlap the well region and the epitaxial layer.

According to implementations, the reliability of semiconductor devices may be improved.

At least some of the above and other features of the invention are set out in the claims.

### BRIEF DESCRIPTION OF THE DRAWINGS

FIG. 1 is a cross-sectional view showing a semiconductor device according to some implementations.
FIGS. 2, 3, 4, 5, 6, 7, 8, 9, 10, 11, and 12 are cross-sectional views illustrating semiconductor devices according to some implementations.
FIGS. 13, 14, 15, 16, 17, 18, 19, 20, and 21 are intermediate process cross-sectional views showing a method for manufacturing a semiconductor device according to some implementations.

### DETAILED DESCRIPTION

Hereinafter, various implementations will be described in detail with reference to the attached drawings so that a person having ordinary skill in the art to which the present disclosure pertains may easily implement the techniques discussed in the disclosure. The present disclosure discussed implementations in many different forms and is not limited to the implementations described herein.

In this disclosure, parts irrelevant to the description are omitted, and the same reference numerals are used for identical or similar components throughout the specification.

In addition, the size and the thickness of each component shown in the drawing are arbitrarily shown for convenience of explanation, so the present disclosure is not necessarily limited to what is shown. To clearly represent the various layers and areas in the drawing, the thickness is enlarged and shown. And in the drawing, for convenience of explanation, the thickness of some layers and areas is exaggerated.

Also, when we say that a part, such as a layer, membrane, region, or plate, is "over" or "on" another part, this includes not only cases where it is "directly over" the other part, but also cases where there are other parts in between. Conversely, when we say that a part is "directly above" another part, we mean that there is no other part in between. Also, being "above" or "on" a reference part means being located above or below the reference part, and does not necessarily mean being located "above" or "on" the opposite direction of gravity.

Additionally, throughout the specification, whenever a part is said to "include" a component, this does not mean that it excludes other components, but rather that it may include other components, unless otherwise specifically stated.

Additionally, throughout the specification, when we say "in plan", we mean when the target portion is viewed from above, and when we say "in cross section", we mean when the target portion is viewed from the side in a cross-section cut vertically.

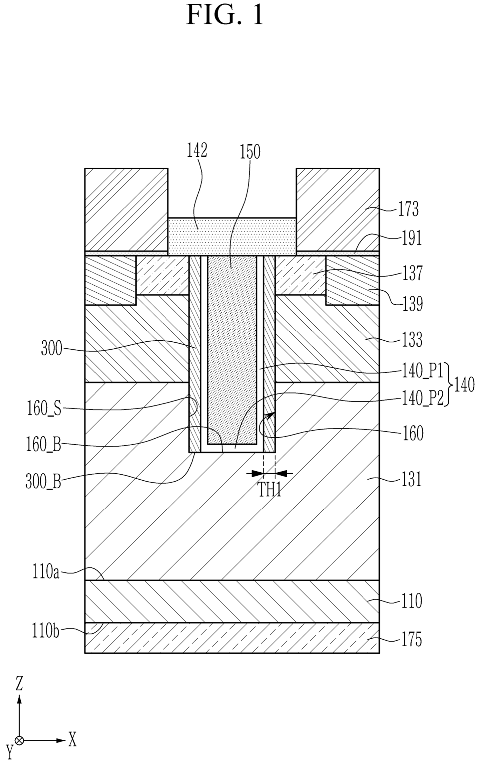

FIG. 1 is a cross-sectional view showing a semiconductor device according to some implementations.

Referring to FIG. 1, a semiconductor device according to some implementations includes a substrate 110 including a first surface 110a and a second surface 110b opposing each other (e.g., the second surface 110b is on a side of the substrate 110 that is an opposite side of the substrate 110 from the first surface 110a), an epitaxial layer 131 positioned on the first surface 110a of the substrate 110 and including a gate trench 160 and having a first conductivity type, a channel layer 300 positioned on an inner sidewall 160_S of the gate trench 160 and having the first conductivity type, a gate electrode 150 positioned on the inner side surface of the channel layer 300, a gate insulating layer 140 positioned between the channel layer 300 and the gate electrode 150 and on a bottom surface 160_B of the gate trench 160, a source electrode 173 positioned on the epitaxial layer 131, and a drain electrode 175 positioned on the second surface 110b of the substrate 110.

The substrate 110 may be a semiconductor substrate including SiC. For example, substrate 110 may be made of a 4H-SiC substrate. In some cases, the substrate 110 may be made of a 3C-SiC substrate, a 6H-SiC substrate, etc. The substrate 110 may have a first conductivity type. The substrate 110 may be doped with first conductivity type impurities. The substrate 110 may be heavily doped with first conductivity type impurities. Here, the first conductivity type may be n-type, but example implementations are not limited thereto. The resistivity of the substrate 110 may be between about 0.005Ωcm and about 0.035Ωcm. The thickness of the substrate 110 may be from about 10 µm to about 700 µm. The material, doping type, doping concentration, resistivity, thickness, etc. of the substrate 110 are not limited thereto and may be variously changed. The substrate 110 may include a first surface 110a and a second surface 110b opposing each other. The first surface 110a of the substrate 110 may be the upper surface, and the second surface 110b of the substrate 110 may be the lower surface.

The epitaxial layer 131 may be positioned on the first surface 110a of the substrate 110, i.e., the upper surface. The lower surface of the epitaxial layer 131 may contact the first surface 110a of the substrate 110. However, example implementations are not limited thereto, and other layers may be additionally positioned between the substrate 110 and the epitaxial layer 131. The epitaxial layer 131 may be an epitaxy layer formed from the substrate 110 using an epitaxial growth method.

The epitaxial layer 131 may include a semiconductor material. For example, the epitaxial layer 131 may include a first material and a second material that is different from the first material. Here, the first material may include silicon (Si), and the second material may include carbon (C). The epitaxial layer 131 may include SiC. As an example, the epitaxial layer 131 may include 4H-SiC. The epitaxial layer 131 may include SiC having a 4H hexagonal crystal structure.

The epitaxial layer 131 may have the first conductivity type. The epitaxial layer 131 may be doped with first conductivity type impurities. The epitaxial layer 131 may be lightly doped with first conductivity type impurities. Here, the first conductivity type may be n-type, but example implementations are not limited thereto. The doping concentration of the epitaxial layer 131 may be lower than the doping concentration of the substrate 110. The doping concentration of the epitaxial layer 131 may be between about 1*10¹⁵cm⁻³ and about 1*10¹⁷cm⁻³. The thickness of the epitaxial layer 131 may be from about 1 µm to about 13 µm. The material, doping type, doping concentration, thickness, etc. of the epitaxial layer 131 are not limited thereto and may be variously changed.

The epitaxial layer 131 may include a gate trench 160. The gate trench 160 may be formed to have a predetermined depth. The gate trench 160 may be formed in a roughly U-shape in cross section. The gate trench 160 may include a bottom surface 160_B and an inner sidewall 160_S extending from the bottom surface 160_B. The inner sidewall 160_S of the gate trench 160 may be defined by the epitaxial layer 131, the well region 133 to be described later, and the first conductivity type doped layer 137. The bottom surface 160_B of the gate trench 160 may be defined by the epitaxial layer 131. In FIG. 1, the angle of the inner sidewall 160_S with respect to the bottom surface 160_B of the gate trench 160 is depicted as being vertical, but example implementations are not limited thereto.

The gate trench 160 may extend in the second direction (Y direction). A semiconductor device according to some implementations may include a plurality of gate trenches 160 extending in the second direction (Y direction). A plurality of gate trenches 160 may be provided, and a plurality of gate trenches 160 may be arranged spaced apart from each other in the first direction (X direction). Each of the multiple gate trenches 160 may extend in the second direction (Y direction). Here, the second direction (Y direction) may mean the direction that intersects the first direction (X direction). For example, the second direction (Y direction) may be orthogonal to the first direction (X direction).

The channel layer 300 may be positioned within gate trench 160. The channel layer 300 may be positioned on the inner sidewall 160_S of the gate trench 160. For example, the channel layer 300 may be positioned entirely on the inner sidewall 160_S of the gate trench 160. The channel layer 300 may be positioned on the side surface of the epitaxial layer 131 defining the inner sidewall 160_S of the gate trench 160 and on the side surface of the well region 133, which will be described later. The channel layer 300 may overlap with the epitaxial layer 131 and the well region 133, which will be described later, in the first direction (X direction), and need not overlap with the source electrode 173, which will be described later, in the first direction (X direction). The channel layer 300 may contact epitaxial layer 131 and the well region 133, which will be described later. Additionally, the channel layer 300 may be positioned on the side surface of the first conductivity type doped layer 137, which will be described later. The channel layer 300 may be overlapped, in the first direction (X direction), with the first conductivity type doped layer 137, which will be described later. The channel layer 300 may be in contact with the first conductivity type doped layer 137, which will be described later. The length of the channel layer 300 in the third direction (Z direction) may be less than or equal to the depth of the gate trench 160 in the third direction (Z direction), but example implementations are not limited thereto. The channel layer 300 may extend on the inner sidewall 160_S of the gate trench 160 in the third direction (Z direction). The channel layer 300 may extend in the second direction (Y direction). The channel layer 300 may function as a channel of the transistor.

The channel layer 300 may be positioned on the inner sidewall 160_S of the gate trench 160 with a substantially uniform thickness TH1. Here, the thickness TH1 of the channel layer 300 may mean the thickness of the channel layer 300 in the first direction (X direction). The thickness TH1 of the channel layer 300 in the first direction (X direction) may be constant as it moves away from the bottom surface 160_B of the gate trench 160, but example implementations are not limited thereto. For example, the thickness TH1 of the channel layer 300 in the first direction (X direction) may be about 1/10 to about 1/3 of the gate trench 160, but example implementations are not limited thereto. For example, the thickness TH1 of the channel layer 300 in the first direction (X direction) may be approximately 100 nm or more, but example implementations are not limited thereto.

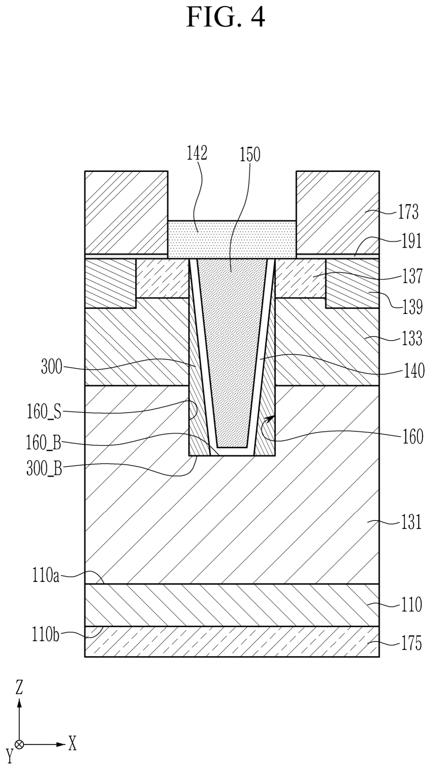

The lower surface 300_B of the channel layer 300 may be aligned with the same boundary as the bottom surface 160_B of the gate trench 160. The lower surface 300_B of the channel layer 300 is a surface of the channel layer 300 that faces the first surface 110a of the substrate 110. That is, the lower surface 300_B of the channel layer 300 and the bottom surface 160_B of the gate trench 160 may be positioned at substantially the same level. The lower surface 300_B of the channel layer 300 and the bottom surface 160_B of the gate trench 160 may be positioned at substantially the same distance from the first surface 110a of the substrate 110. Accordingly, the lower surface 300_B of the channel layer 300 and the lower surface of the gate insulating layer 140 (where the lower surface of the gate insulating layer 140 is a surface of the gate insulating layer 140 that faces the first surface 110a of the substrate 100) to be described later may be positioned at substantially the same level, but example implementations are not limited thereto. The lower surface 300_B of the channel layer 300 and the lower surface of the gate insulating layer 140 to be described later may be positioned at substantially the same distance from the first surface 110a of the substrate 110. A distance between the lower surface of the gate insulating layer and the first surface of the substrate may be equal to a distance between the lower surface of the channel layer and the first surface of the substrate. However, example implementations are not limited thereto, and the channel layer 300 may be positioned only on a portion of the inner sidewall 160_S of the gate trench 160. In this case, the lower surface 300_B of the channel layer 300 may be positioned at a higher level than the bottom surface 160_B of the gate trench 160. A description of this will be given later, referring to FIG. 4.

The channel layer 300 may protrude from the lower surface of the well region 133, which will be described later, toward the first surface 110a of the substrate 110. The lower surface 300_B of the channel layer 300 may be positioned at a lower level than the lower surface of the well region 133. The lower surface 300_B of the channel layer 300 may be positioned closer to the first surface 110a of the substrate 110 than to the lower surface of the well region 133.

The upper surface of the channel layer 300 may be positioned at substantially the same level as the upper surface of the first conductivity type doped layer 137, which will be described later. The upper surface of the channel layer 300 and the upper surface of the first conductivity type doped layer 137 to be described later may be positioned at substantially the same distance from the first surface 110a of the substrate 110. The upper surface of the channel layer 300 may be positioned at substantially the same level as the upper surface of the second conductivity type doped layer 139, which will be described later. The upper surface of the channel layer 300 and the upper surface of the gate electrode 150 to be described later may be positioned at substantially the same distance from the first surface 110a of the substrate 110. The upper surface of the channel layer 300 and the upper surface of the gate insulating layer 140 to be described later may be positioned at substantially the same distance from the first surface 110a of the substrate 110.

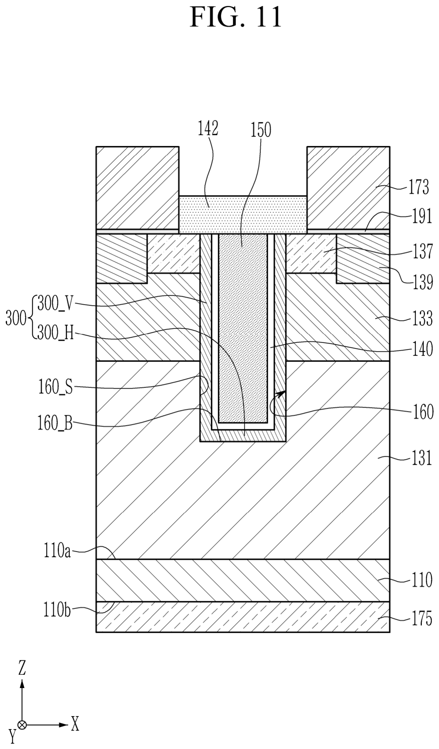

The channel layer 300 need not be positioned on at least a portion of the bottom surface 160_B of the gate trench 160. For example, the channel layer 300 extends in the third direction (Z direction) so that the lower surface 300_B may contact the bottom surface 160_B of the gate trench 160. In this case, the channel layer 300 need not overlap with the gate electrode 150 in the third direction (Z direction) to be described later. However, example implementations are not limited thereto, and as another example, the channel layer 300 may be positioned entirely on the bottom surface 160_B of the gate trench 160. A description of this will be given later, referring to FIG. 11.

The channel layer 300 may be an epitaxy layer formed from the epitaxial layer 131 using an epitaxial growth method. For example, the channel layer 300 may be an epitaxy layer grown from a portion of the epitaxial layer 131 exposed by the inner sidewall 160_S of the gate trench 160. The channel layer 300 may include a semiconductor material. The channel layer 300 may comprise the same material as epitaxial layer 131. For example, the channel layer 300 may include a first material and a second material different from the first material. Here, the first material may include silicon (Si), and the second material may include carbon (C). For example, the channel layer 300 may include SiC.

The channel layer 300 may have a different crystal structure than the epitaxial layer 131. For example, the channel layer 300 may include 3C-SiC. The channel layer 300 may include SiC having a 3C cubic crystal structure. In contrast, the epitaxial layer 131 may include 4H-SiC. The epitaxial layer 131 may include SiC having a 4H hexagonal crystal structure. The channel layer 300 may include a material having a different energy band gap than the epitaxial layer 131. For example, the energy band gap of the material constituting the channel layer 300 may be smaller than the energy band gap of the material constituting the epitaxial layer 131.

The content (at%) of the first material of the channel layer 300 may be substantially the same as the content (at%) of the first material of the epitaxial layer 131, but example implementations are not limited thereto. Here, the first material may include silicon (Si), and the second material may include carbon (C). The channel layer 300 may have the same conductivity type as epitaxial layer 131. The channel layer 300 may have the first conductivity type. The channel layer 300 may be doped with first conductivity type impurities. The channel layer 300 may be lightly doped with first conductivity type impurities. Here, the first conductivity type may be n-type, but example implementations are not limited thereto. The doping concentration of the channel layer 300 may be lower than the doping concentration of the substrate 110. The doping concentration of the channel layer 300 may be about 1*10¹⁵cm⁻³ or more and about 1*10¹⁷cm⁻³ or less. The material, doping type, doping concentration, etc. of the channel layer 300 are not limited to this and may be changed in various ways.

In some implementations, the semiconductor device may have a defect occur in a portion of the epitaxial layer 131 defining an inner sidewall 160_S of the gate trench 160 and a portion of the epitaxial layer 131 defining a bottom surface 160_B of the gate trench 160 during a process of forming a gate trench 160 by etching at least a portion of the epitaxial layer 131. The semiconductor device according to some implementations may include a channel layer 300 including the same material as the epitaxial layer 131 and having a different crystal structure on an inner sidewall 160_S of the gate trench 160. The channel layer 300 includes a material having a lower defect rate than the epitaxial layer 131. For example, channel layer 300 may include 3C-SiC, which has a lower defect rate than the epitaxial layer 131, which, in some implementations, may include 4H-SiC. Accordingly, even if a defect occurs in at least a portion of the epitaxial layer 131 during the process of forming the gate trench 160, the reliability of the semiconductor device according to some implementations may be improved because the channel layer 300 has a relatively low defect rate.

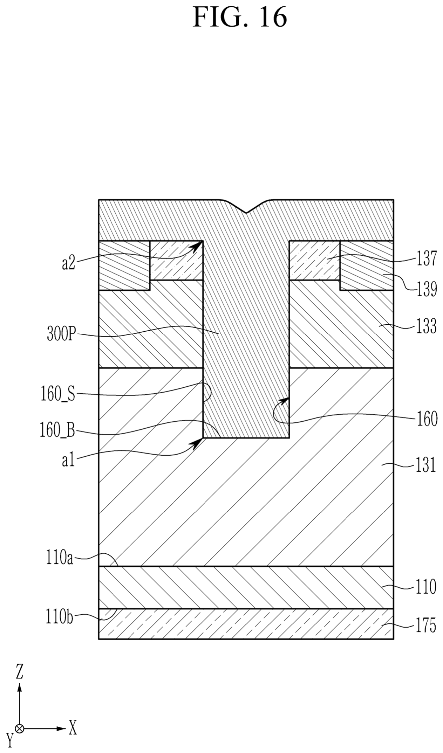

Meanwhile, in a semiconductor device according to some implementations, when a channel layer 300 is formed on a surface of the epitaxial layer 131, a defect may occur in a portion of the channel layer 300 depending on the crystal plane of the growing the channel layer 300. For example, when forming a channel material layer (see 300P of FIG. 16) within a gate trench 160, a defect may occur in a portion of the channel material layer (see 300P of FIG. 16) formed at a point where the bottom surface 160_B of the gate trench 160 and the inner sidewall 160_S meet (see a1 of FIG. 16), a portion of the channel material layer (see 300P of FIG. 16) formed at a point where the inner sidewall 160_S of the gate trench 160 and the upper surface of the first conductivity type doped layer 137 meet (see a2 of FIG. 16), and a portion of the channel material layer (see 300P of FIG. 16) formed on the bottom surface 160_B of the gate trench 160. According to some implementations, a semiconductor device may form a channel layer 300 by etching at least a portion of the channel material layer (see 300P of FIG. 16) after forming the channel material layer (see 300P of FIG. 16). In this process, defects occurring within the channel layer 300 may be removed, and thus, the reliability of the semiconductor device may be improved.

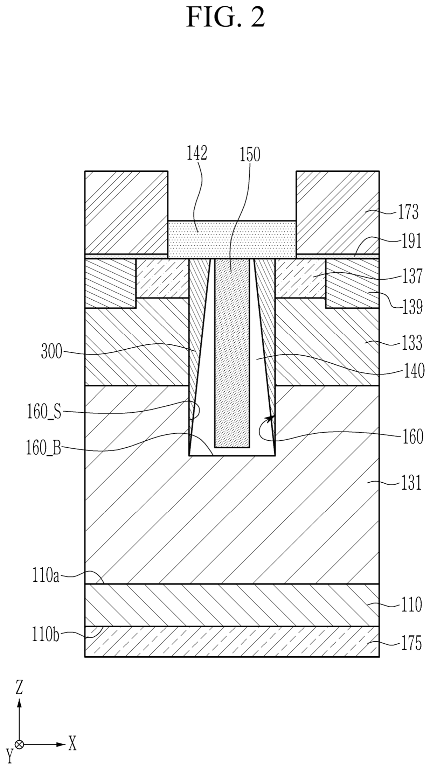

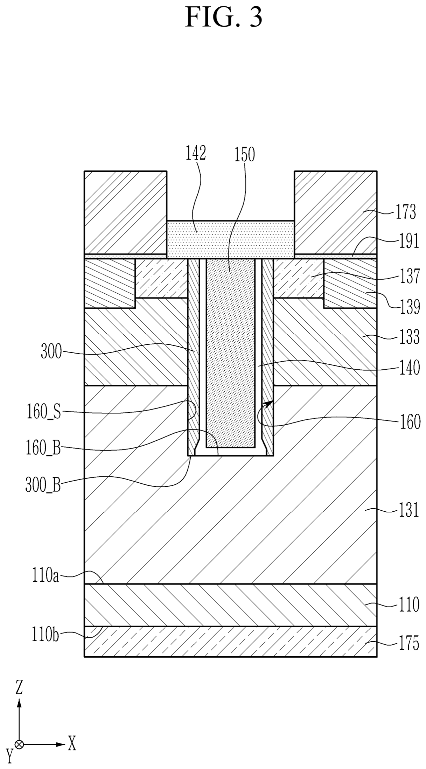

The gate electrode 150 is positioned within the gate trench 160. The gate electrode 150 may extend in the second direction (Y direction). The gate electrode 150 may be spaced from the epitaxial layer 131. The gate electrode 150 may be spaced apart from the epitaxial layer 131 by a substantially constant interval. However, example implementations are not limited thereto, and the distance between the gate electrode 150 and the epitaxial layer 131 may vary depending on the location. The gate electrode 150 may have a cross-sectional shape similar to, but not limited to, the gate trench 160. A description of this is given in FIG. 2 and referring to FIG. 3, as described below.

The gate electrode 150 may be spaced apart from the channel layer 300 in the first direction (X direction). The gate electrode 150 may be spaced apart from the channel layer 300 by a substantially constant interval. However, example implementations are not limited thereto, and the distance between the gate electrode 150 and the channel layer 300 may vary depending on the location.

The gate electrode 150 may include a lower surface and side surfaces extending from the lower surface. The gate electrode 150 may further include an upper surface opposing the lower surface, and side surfaces may connect between the lower surface and the upper surface. The lower surface of the gate electrode 150 may face the bottom surface 160_B of the gate trench 160. The side surfaces of the gate electrode 150 may face the inner side surface of the channel layer 300. The lower surface of the gate electrode 150 may be positioned at a higher level than the lower surface 300_B of the channel layer 300. The lower surface of the gate electrode 150 may be positioned farther from the first surface 110a of the substrate 110 than the lower surface 300_B of the channel layer 300.

The gate electrode 150 may include a conductive material. For example, the gate electrode 150 may include polysilicon doped with impurities. As another example, the gate electrode 150 may include a metal, a metal alloy, a conductive metal nitride, a metal silicide, a doped semiconductor material, a conductive metal oxide, a conductive metal nitride, or a combination thereof. The gate electrode 150 may be formed of a single layer or multiple layers.

The gate insulating layer 140 is positioned between the channel layer 300 and the gate electrode 150. The gate insulating layer 140 may be positioned on the inner side surface of the channel layer 300. The gate insulating layer 140 may cover the side surface of the gate electrode 150. The gate insulating layer 140 may be in contact with the channel layer 300. Additionally, the gate insulating layer 140 may be positioned on the bottom surface 160_B of the gate trench 160. The gate insulating layer 140 may be positioned between the epitaxial layer 131 and the gate electrode 150. The gate insulating layer 140 may be positioned under the gate electrode 150 and may cover a lower surface of the gate electrode 150. The lower surface of the gate insulating layer 140 may be in contact with the epitaxial layer 131. The gate electrode 150 may be insulated from the epitaxial layer 131 and the channel layer 300 by the gate insulating layer 140. The gate electrode 150 may be surrounded by the gate insulating layer 140. The gate insulating layer 140 may be positioned with a substantially uniform thickness on the bottom surface 160_B of the gate trench 160 and the inner side surface of the channel layer 300, but example implementations are not limited thereto.

The lower surface of the gate insulating layer 140 may be positioned at substantially the same level as the lower surface 300_B of the channel layer 300. The lower surface of the gate insulating layer 140 and the lower surface 300_B of the channel layer 300 may be positioned at substantially the same distance from the first surface 110a of the substrate 110. A distance between the lower surface of the gate insulating layer and the first surface of the substrate may be equal to a distance between the lower surface of the channel layer and the first surface of the substrate. The lower surface of the gate insulating layer 140 may be positioned at a lower level than the lower surface of the gate electrode 150. The lower surface of the gate insulating layer 140 may be positioned closer to the first surface 110a of the substrate 110 than the lower surface of the gate electrode 150.

According to some implementations, a gate insulating layer 140 of a semiconductor device includes a first portion 140_P1 positioned on an inner side surface of a channel layer 300 and a second portion 140_P2 positioned on a bottom surface 160_B of a gate trench 160.

The first portion 140_P1 may extend in the third direction (Z direction). The first portion 140_P1 may extend parallel to the channel layer 300. The first portion 140_P1 may be positioned between the channel layer 300 and the gate electrode 150. The first portion 140_P1 may be in contact with the inner side surface of the channel layer 300 and the side surface of the gate electrode 150. The first portion 140_P1 may refer to a portion of the gate insulating layer 140 positioned between the channel layer 300 and the gate electrode 150 and extending in the third direction (Z direction).

The upper surface of the first portion 140_P1 may be positioned at substantially the same level as the upper surface of the channel layer 300. The upper surface of the first portion 140_P1 and the upper surface of the channel layer 300 may be positioned at substantially the same distance from the first surface 110a of the substrate 110. Additionally, the upper surface of the first portion 140_P1 may be positioned at substantially the same level as the upper surface of the first conductivity type doped layer 137, which will be described later. The upper surface of the first portion 140_P1 and the upper surface of the first conductivity type doped layer 137 to be described later may be positioned at substantially the same distance from the first surface 110a of the substrate 110.

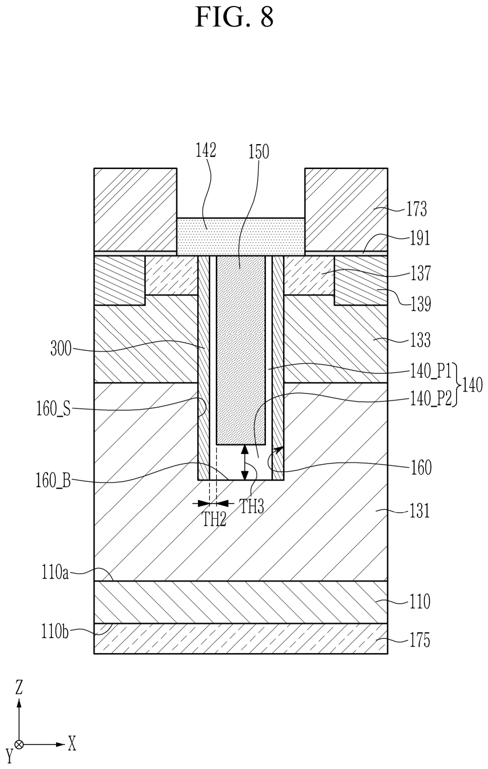

The second portion 140_P2 may be positioned on the bottom surface 160_B of the gate trench 160. The second portion 140_P2 may be conformally positioned on the bottom surface 160_B of the gate trench 160. The second portion 140_P2 may extend in the first direction (X direction). The second portion 140_P2 may be connected to the first portion 140_P1. The second portion 140_P2 may refer to a portion of the gate insulating layer 140 positioned on the bottom surface 160_B of the gate trench 160. The thickness of the second portion 140_P2 along the third direction (Z direction) may be substantially the same as the thickness of the first portion 140_P1 along the first direction (X direction), but example implementations are not limited thereto. For example, the thickness of the second portion 140_P2 along the third direction (Z direction) may be greater than the thickness of the first portion 140_P1 along the first direction (X direction). A description of this will be given later, referring to FIG. 8.

The gate insulating layer 140 may include an insulating material. For example, the gate insulating layer 140 may include silicon oxide (SiO₂). However, example implementations are not limited thereto, and the material of the gate insulating layer 140 may be changed in various ways. As another example, the gate insulating layer 140 may include SiN, SiON, SiC, SiCN or a combination thereof. In some implementations, the gate insulating layer 140 may further include certain elements. For example, the gate insulating layer 140 may include carbon (C), nitrogen (N), or a combination thereof. For example, the gate insulating layer 140 may be composed of silicon oxide (SiO₂) containing carbon (C) and nitrogen (N). The gate insulating layer 140 may be formed of a single layer or multiple layers.

A semiconductor device according to some implementations may further include a capping layer 142 positioned on the gate electrode 150.

The capping layer 142 may cover the upper surface of the gate electrode 150. Additionally, the capping layer 142 may cover at least a portion of the channel layer 300, the gate insulating layer 140 adjacent to the gate electrode 150, and the first conductivity type doped layer 137 to be described later. The capping layer 142 may be positioned between the source electrodes 173, which will be described later. The thickness of the capping layer 142 along the third direction (Z direction) may be almost constant. However, example implementations are not limited thereto, and the thickness of the capping layer 142 in the third direction (Z direction) may gradually decrease from the center of the capping layer 142 to opposite edges. The thickness of the capping layer 142 may be different from the thickness of the gate insulating layer 140. For example, the thickness of the capping layer 142 may be thicker than the thickness of the gate insulating layer 140. In some cases, the thickness of the capping layer 142 may be similar to the thickness of the gate insulating layer 140.

The capping layer 142 may include an insulating material. For example, the capping layer 142 may include SiO₂, SiOP, SiN, SiON or a combination thereof. However, example implementations are not limited thereto, and the material of the capping layer 142 may be changed in various ways. The capping layer 142 may be formed as a single layer or multiple layers. The capping layer 142 may include the same material as the gate insulating layer 140, or may include a different material. When the capping layer 142 is made of the same material as the gate insulating layer 140, the boundary between the capping layer 142 and the gate insulating layer 140 need not be clearly distinguished at the portion where the capping layer 142 and the gate insulating layer 140 come into contact.

The source electrode 173 is positioned on the epitaxial layer 131. The source electrode 173 may be positioned on the upper surface of the first conductivity type doped layer 137 and the upper surface of the second conductivity type doped layer 139, which will be described later.

The source electrode 173 may be positioned spaced apart from the gate trench 160. For example, the source electrode 173 may be positioned spaced apart from the gate trench 160 in the first direction (X direction). The source electrode 173 may be positioned spaced apart from the channel layer 300 in the first direction (X direction). The source electrode 173 need not overlap with the gate trench 160 and the gate electrode 150 in the third direction (Z direction). The source electrode 173 need not overlap with the channel layer 300 in the third direction (Z direction).

The source electrode 173 may include a conductive material. For example, the source electrode 173 may include a metal, a metal alloy, a conductive metal nitride, a metal silicide, a doped semiconductor material, a conductive metal oxide, or a conductive metal nitride. For example, the source electrode 173 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbide nitride (TiAIC-N), titanium aluminum carbide (TiAIC), titanium carbide (TiC), tantalum carbide nitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or combinations thereof, but example implementations are not limited thereto. The source electrode 173 may be formed of a single layer or multiple layers.

A semiconductor device according to some implementations may further include a well region 133 positioned on the epitaxial layer 131.

The well region 133 may be positioned on the epitaxial layer 131. The well region 133 may be positioned between the epitaxial layer 131 and source electrode 173. The well region 133 may be positioned on a portion of epitaxial layer 131 adjacent to gate trench 160. The well region 133 may face gate insulating layer 140 with the channel layer 300 in between. The well region 133 may be positioned apart from gate insulating layer 140 in the first direction (X direction). The well region 133 may be in contact with the channel layer 300, but example implementations are not limited thereto.

The well region 133 may be conformally positioned on the epitaxial layer 131. The well region 133 may be an epitaxy layer formed from the epitaxial layer 131 using an epitaxial growth method. Alternatively, the well region 133 may be a doped region formed using an ion implantation process within the epitaxial layer 131.

The well region 133 may include a semiconductor material. For example, the well region 133 may include a first material and a second material that is different from the first material. Here, the first material may include silicon (Si), and the second material may include carbon (C). The well region 133 may include SiC. As an example, the well region 133 may include 4H-SiC. The well region 133 may have a second conductivity type that is different from the first conductivity type. The well region 133 may be doped with a second conductivity type impurity. The well region 133 may be lightly doped with second conductivity type impurities. Here, the second conductivity type may be p-type, but example implementations are not limited thereto. The doping concentration in the well region 133 may be between about 1*10¹⁷cm⁻³ and about 1*10¹⁹cm⁻³. The thickness of the well region 133 may be about 0.3 µm or more and about 1.1 µm or less, but example implementations are not limited thereto. The material, doping type, doping concentration, thickness, etc. of the well region 133 are not limited thereto and may be variously changed.

A semiconductor device according to some implementations may further include a first conductivity type doped layer 137 and a second conductivity type doped layer 139 positioned on the well region 133.

The first conductivity type doped layer 137 may be positioned on the epitaxial layer 131. The first conductivity type doped layer 137 may be positioned on the well region 133. The first conductivity type doped layer 137 may be positioned between the well region 133 and the source electrode 173.

The first conductivity type doped layer 137 may be positioned on opposite sides of the gate trench 160 along the first direction (X direction). The gate trench 160 may be positioned between first conductivity type doped layers 137 spaced apart from each other along the first direction (X direction). The first conductivity type doped layer 137 need not overlap with the gate trench 160 in the third direction (Z direction). The first conductivity type doped layer 137 need not overlap with the channel layer 300 in the third direction (Z direction). The side surface of the first conductivity type doped layer 137 may be in contact with the channel layer 300, but example implementations are not limited thereto. The first conductivity type doped layer 137 need not cover the gate trench 160.

The first conductivity type doped layer 137 may face the gate insulating layer 140 with the channel layer 300 in between. The side surface of the first conductivity type doped layer 137 opposing the gate insulating layer 140 may be positioned on the same boundary as the side wall of the gate trench 160. The lower surface of the first conductivity type doped layer 137 may be in contact with the well region 133, and the upper surface of the first conductivity type doped layer 137 may be in contact with the metal silicide layer 191 (or source electrode 173). The source electrode 173 and the metal silicide layer 191 may be in ohmic contact with the first conductivity type doped layer 137.

The region in contact with the metal silicide layer 191 within the first conductivity type doped layer 137 may be doped at a relatively high concentration compared to other regions. However, example implementations are not limited thereto, and another layer may be positioned between the first conductivity type doped layer 137 and the source electrode 173. At least a portion of the upper surface of the first conductivity type doped layer 137 may be covered by the capping layer 142, but example implementations are not limited thereto.

The first conductivity type doped layer 137 may be a doping region formed using an ion implantation process within the well region 133. The first conductivity type doped layer 137 may include a semiconductor material. For example, the first conductivity type doped layer 137 may include a first material and a second material different from the first material. Here, the first material may include silicon (Si), and the second material may include carbon (C). The first conductivity type doped layer 137 may include SiC. As an example, the first conductivity type doped layer 137 may include 4H-SiC. The first conductivity type doped layer 137 may have a first conductivity type. The first conductivity type doped layer 137 may be doped with first conductivity type impurities. The first conductivity type doped layer 137 may be heavily doped with first conductivity type impurities. Here, the first conductivity type may be n-type, but example implementations are not limited thereto. The doping concentration of the first conductivity type doped layer 137 may be greater than the doping concentration of the epitaxial layer 131. The doping concentration of the first conductivity type doped layer 137 may be about 1*10¹⁸cm⁻³ or more and about 5*10²⁰cm⁻³ or less. The thickness of the first conductivity type doped layer 137 may be about 0.1 µm or more and about 0.5 µm or less. The material, doping type, doping concentration, etc. of the first conductivity type doped layer 137 are not limited thereto and may be changed in various ways.

The second conductivity type doped layer 139 may be positioned on the well region 133. The second conductivity type doped layer 139 may be positioned between the well region 133 and the source electrode 173.

In some implementations, the second conductivity type doped layer 139 may be positioned on one side of the first conductivity type doped layer 137. For example, the second conductivity type doped layer 139 may be positioned on one side of the first conductivity type doped layer 137 along the first direction (X direction). That is, the first conductivity type doped layer 137 may be positioned between the second conductivity type doped layer 139 and the channel layer 300. The second conductivity type doped layer 139 may be positioned spaced apart from the gate trench 160 in the first direction (X direction). The second conductivity type doped layer 139 may be positioned spaced apart from the channel layer 300 in the first direction (X direction).

The second conductivity type doped layer 139 may be positioned in the same layer as the first conductivity type doped layer 137. The upper surface of the second conductivity type doped layer 139 may be positioned at substantially the same level as the upper surface of the first conductivity type doped layer 137. The upper surface of the second conductivity type doped layer 139 and the upper surface of the first conductivity type doped layer 137 may be positioned at substantially the same distance from the first surface 110a of the substrate 110. The lower surface of the second conductivity type doped layer 139 may be positioned at a lower level than the lower surface of the first conductivity type doped layer 137, but example implementations are not limited thereto. The lower surface of the second conductivity type doped layer 139 may be positioned closer to the first surface 110a of the substrate 110 than the lower surface of the first conductivity type doped layer 137, but example implementations are not limited thereto.

The second conductivity type doped layer 139 may be a doping region formed using an ion implantation process within the epitaxial layer 131. The second conductivity type doped layer 139 may include a semiconductor material. For example, the second conductivity type doped layer 139 may include a first material and a second material different from the first material. Here, the first material may include silicon (Si), and the second material may include carbon (C). The second conductivity type doped layer 139 may include SiC. As an example, the second conductivity type doped layer 139 may include 4H-SiC. The second conductivity type doped layer 139 may have a second conductivity type. The second conductivity type doped layer 139 may be doped with a second conductivity type impurity. The second conductivity type doped layer 139 may be heavily doped with second conductivity type impurities. Here, the second conductivity type may be p-type, but example implementations are not limited thereto. The doping concentration of the second conductivity type doped layer 139 may be greater than the doping concentration of the well region 133. The doping concentration of the second conductivity type doped layer 139 may be about 1*10¹⁸cm⁻³ or more and about 5*10²⁰cm⁻³ or less. The material, doping type, doping concentration, etc. of the second conductivity type doped layer 139 are not limited thereto and may be changed in various ways.

A semiconductor device according to some implementations may further include a metal silicide layer 191 positioned between the source electrode 173 and the well region 133. For example, a metal silicide layer 191 may be positioned between the first conductivity type doped layer 137 and the source electrode 173 and between the second conductivity type doped layer 139 and the source electrode 173. The first conductivity type doped layer 137 and the source electrode 173 and the second conductivity type doped layer 139 and the source electrode 173 may be electrically smoothly connected by the metal silicide layer 191. The metal silicide layer 191 may be in contact with the first conductivity type doped layer 137, the second conductivity type doped layer 139, and the source electrode 173, but example implementations are not limited thereto.

The drain electrode 175 may be positioned on the second surface 110b of the substrate 110, i.e., the lower surface. The upper surface of the drain electrode 175 may be in contact with the second surface 110b of the substrate 110. The drain electrode 175 may be in ohmic contact with the substrate 110. The region in contact with the drain electrode 175 within the substrate 110 may be doped at a relatively high concentration compared to other regions. However, example implementations are not limited thereto, and other layers may be additionally positioned between the drain electrode 175 and the substrate 110. For example, an additional silicide layer may be positioned between the drain electrode 175 and the substrate 110. The drain electrode 175 and the substrate 110 may be electrically smoothly connected by the silicide layer.

The drain electrode 175 may include a conductive material. For example, the drain electrode 175 may include a metal, a metal alloy, a conductive metal nitride, a metal silicide, a doped semiconductor material, a conductive metal oxide, or a conductive metal nitride. The drain electrode 175 may be made of the same material as the source electrode 173, or may be made of a different material. The drain electrode 175 may be formed of a single layer or multiple layers.

A semiconductor device according to some implementations may be an n-type field effect transistor (n-FET). However, example implementations are not limited thereto, and the semiconductor device according to some implementations may be a p-type field effect transistor (p-FET). In this case, the substrate 110, the epitaxial layer 131, and the first conductivity type doped layer 137 may be doped with p-type, and the well region 133 may be doped with n-type.

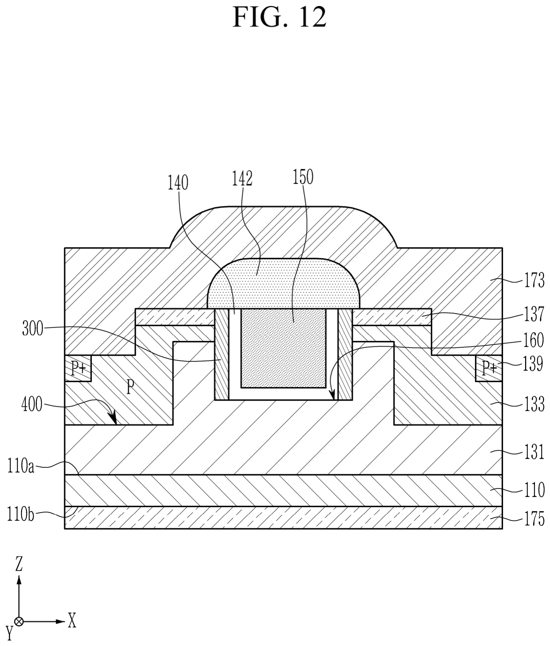

The semiconductor device according to some implementations has been described as having a structure in which the gate electrode 150 is positioned within the gate trench 160 and the source electrode 173 is positioned at a higher layer than the gate electrode 150, but example implementations are not limited thereto. For example, a semiconductor device according to some implementations may include a gate electrode 150 positioned within a gate trench 160, and a source electrode 173 positioned within a source trench (see 400 of FIG. 12) adjacent to one side of the gate trench 160. A description of this will be given later, referring to FIG. 12. As another example, a semiconductor device according to some implementations may have the gate electrode 150 positioned on an upper surface of the epitaxial layer 131, and the source electrode 173 positioned between the gate electrode 150 and the epitaxial layer 131. As another example, a semiconductor device according to some implementations may include a Si IGBT (Insulated Gate Bipolar Transistor) structure. As another example, a semiconductor device according to some implementations may include a superjunction structure in which the p-type region and the n-type region are completely depleted, thereby forming a two-dimensional uniform electric field distribution.

Hereinafter, referring to FIGS. 2 to 12, semiconductor devices according to some implementations will be described.

FIGS. 2 to 12 are cross-sectional views illustrating semiconductor devices according to some implementations.

FIGS. 2 to 12 illustrate various modifications of a semiconductor device according to some implementations illustrated in FIG. 1. The implementations illustrated in FIGS. 2 to 12 are substantially the same as the implementation illustrated in FIG. 1, so a description thereof will be omitted and the differences will be mainly explained. Additionally, the same drawing symbols are used for the same components as in the previous implementation.

Referring to FIGS. 2 to 4, the channel layer 300 of the semiconductor device according to some implementations may have various shapes. The inner side surface of the channel layer 300 may have a shape inclined from the inner sidewall 160_S of the gate trench 160. For example, as illustrated in FIG. 2 and FIG. 3, the channel layer 300 may include a portion whose thickness increases as it moves away from the bottom surface 160_B of the gate trench 160. The thickness of the channel layer 300 in the first direction (X direction) may increase as it moves away from the bottom surface 160_B of the gate trench 160. As another example, the channel layer 300 may include a portion whose thickness decreases as it moves away from the bottom surface 160_B of the gate trench 160. As another example, the channel layer 300 may include a concave recess toward the well region 133. This may be a structure formed in a process of forming a channel layer 300 by removing at least a portion of the channel material layer (see 300P of FIG. 16) after forming the channel material layer (see 300P of FIG. 16) within the gate trench 160. As another example, as illustrated in FIG. 4, the thickness of the channel layer 300 in the first direction (X direction) may decrease as it moves away from the bottom surface 160_B of the gate trench 160. The length of the channel layer 300 in the third direction (Z direction) may be less than the depth of the gate trench 160 in the third direction (Z direction), but example implementations are not limited thereto. The lower surface 300_B of the channel layer 300 and the bottom surface 160_B of the gate trench 160 may be positioned at substantially the same distance from the first surface 110a of the substrate 110. However, example implementations are not limited thereto, and in some implementations, the length of the channel layer 300 of the semiconductor device along the third direction (Z direction) may be smaller than the depth of the gate trench 160 along the third direction (Z direction).

In some implementations, the side surface of the gate electrode 150 may have a shape that is inclined from the inner sidewall 160_S of the gate trench 160. For example, as illustrated in FIG. 4, the thickness of the channel layer 300 in the first direction (X direction) may increase as it moves away from the bottom surface 160_B of the gate trench 160. This may be due to the process characteristics in which the channel layer 300 is filled and the gate insulating layer 140 and the gate electrode 150 are formed in the remaining gate trench 160 portion.

However, example implementations are not limited thereto, and as illustrated in FIG. 2, the side surface of the gate electrode 150 need not extend in a direction parallel to the inner sidewall 160_S of the gate trench 160. This is because the gate insulating layer 140 is not uniformly formed within a space having a reverse taper shape as the channel layer 300 includes a portion whose thickness increases as it moves away from the bottom surface 160_B of the gate trench 160.

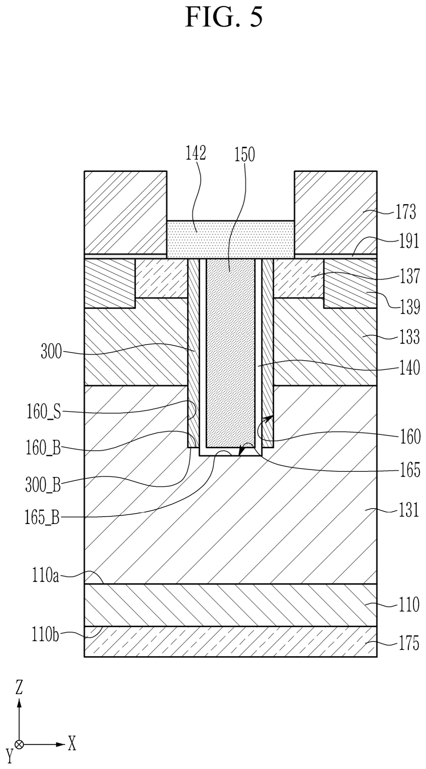

Referring to FIG. 5, the epitaxial layer 131 of the semiconductor device according to some implementations may further include a recess 165 recessed from the bottom surface 160_B of the gate trench 160.

The recess 165 may be positioned to have a predetermined depth from the bottom surface 160_B of the gate trench 160. The recess 165 may be recessed from the bottom surface 160_B of the gate trench 160 toward the first surface 110a of the substrate 110. The recess 165 may be positioned between the channel layers 300 positioned on the inner sidewall 160_S of the gate trench 160. The recess 165 may be formed roughly in the shape of a U in cross section. The bottom surface 165_B of the recess 165 may be defined by the epitaxial layer 131. The bottom surface 165_B of the recess 165 may be positioned at a lower level than the bottom surface 160_B of the gate trench 160. The bottom surface 165_B of the recess 165 may be positioned closer to the first surface 110a of the substrate 110 than the bottom surface 160_B of the gate trench 160. The bottom surface 165_B of the recess 165 may be positioned at a lower level than the lower surface 300_B of the channel layer 300. The bottom surface 165_B of the recess 165 may be positioned closer to the first surface 110a of the substrate 110 than the lower surface 300_B of the channel layer 300. The recess 165 need not overlap with the channel layer 300 in the third direction (Z direction). The recess 165 may be a space formed by removing at least a portion of the epitaxial layer 131 constituting the bottom surface 160_B of the gate trench 160 during the process of forming the channel layer 300 by removing at least a portion of the channel material layer (see 300P of FIG. 16) within the gate trench 160.

In some implementations, the gate insulating layer 140 may be positioned within the recess 165. The gate insulating layer 140 and/or the gate electrode 150 may fill the recess 165. The gate insulating layer 140 may protrude from the lower surface 300_B of the channel layer 300 toward the first surface 110a of the substrate 110. The lower surface of the gate insulating layer 140 may be positioned at a lower level than the lower surface 300_B of the channel layer 300. The lower surface of the gate insulating layer 140 may be positioned closer to the first surface 110a of the substrate 110 than to the lower surface 300_B of the channel layer 300.

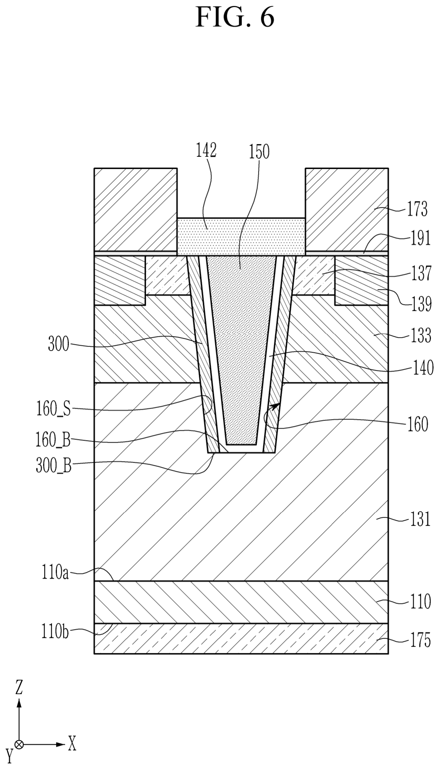

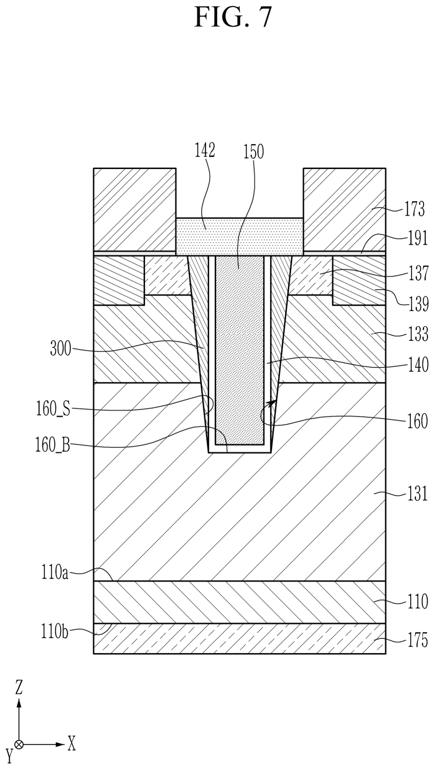

FIG. 6 and referring to FIG. 7, the gate trench 160 of the semiconductor device according to some implementations may have a trapezoidal shape in cross-section. The width of the gate trench 160 in the first direction (X direction) may increase as it moves away from the first surface 110a of the substrate 110. The angle of the inner sidewall 160_S with respect to the bottom surface 160_B of the gate trench 160 may be an obtuse angle, but example implementations are not limited thereto.

In some implementations, the channel layer 300 may be positioned on the inner sidewall 160_S of the gate trench 160. For example, as illustrated in FIG. 6, the channel layer 300 may be positioned with a substantially uniform thickness on the inner sidewall 160_S of the gate trench 160. The thickness of the channel layer 300 in the first direction (X direction) may be constant. The angle of the inner side surface of the channel layer 300 with respect to the bottom surface 160_B of the gate trench 160 may be an obtuse angle. As another example, as illustrated in FIG. 7, the thickness of the channel layer 300 in the first direction (X direction) may decrease as it moves away from the bottom surface 160_B of the gate trench 160. The angle of the inner side surface of the channel layer 300 with respect to the bottom surface 160_B of the gate trench 160 may be vertical, but example implementations are not limited thereto. The lower surface 300_B of the channel layer 300 and the bottom surface 160_B of the gate trench 160 may be positioned at substantially the same distance from the first surface 110a of the substrate 110.

Referring to FIG. 8, the gate insulating layer 140 of a semiconductor device according to some implementations may include portions having different thicknesses. For example, the thickness TH3 of the second portion 140_P2 of the gate insulating layer 140 along the third direction (Z direction) may be greater than the thickness TH2 of the first portion 140_P1 along the first direction (X direction). The distance between the epitaxial layer 131 and the gate electrode 150 in the third direction (Z direction) may be greater than the distance between the channel layer 300 and the gate electrode 150 in the first direction (X direction). Accordingly, the electric field formed from the drain electrode 175 and/or the epitaxial layer 131 may be prevented from being concentrated on the gate electrode 150, and the breakdown voltage of the semiconductor device according to the implementation may be improved.

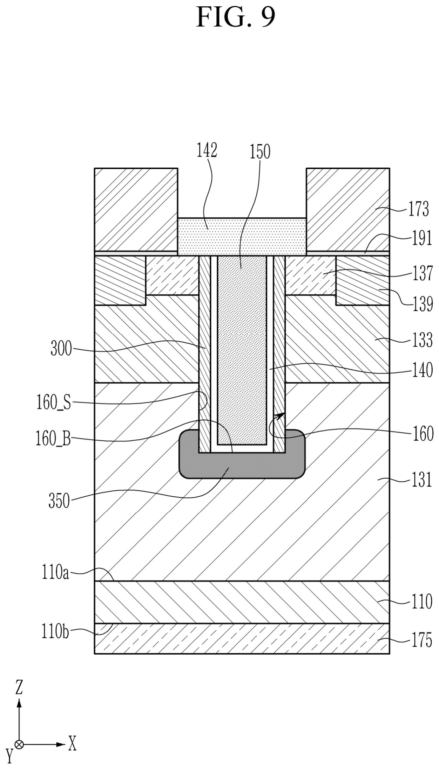

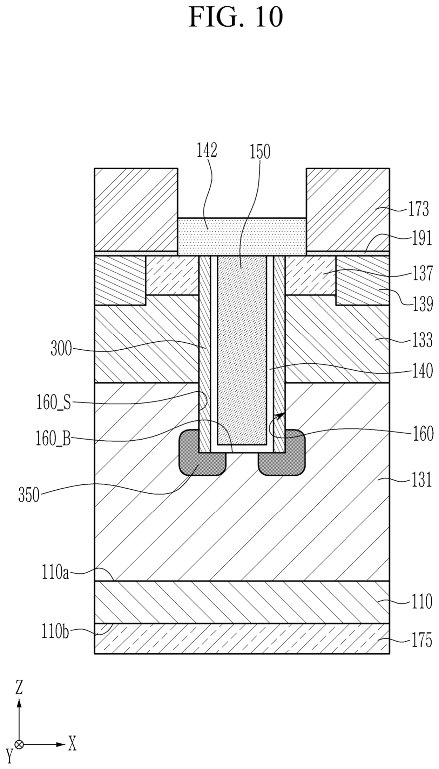

FIG. 9 and referring to FIG. 10, the semiconductor device according to some implementations may further include a shield pattern 350 positioned between the epitaxial layer 131 and the gate insulating layer 140.

The shield pattern 350 may be positioned on the epitaxial layer 131. The shield pattern 350 may be positioned below gate trench 160. The shield pattern 350 may be positioned between the epitaxial layer 131 and the gate insulating layer 140. The shield pattern 350 may be positioned between the epitaxial layer 131 and the channel layer 300. For example, the shield pattern 350 may be positioned between the outer surface of the channel layer 300 and the epitaxial layer 131 and between the lower surface of the channel layer 300 and the epitaxial layer 131. The shield pattern 350 may surround at least a portion of the channel layer 300. The shield pattern 350 may interface with the channel layer 300, but example implementations are not limited thereto. The shield pattern 350 may be positioned below gate trench 160. For example, as illustrated in FIG. 9, the shield pattern 350 may be positioned entirely beneath the gate trench 160. In this case, the bottom surface 160_B of the gate trench 160 may be defined by the shield pattern 350. As another example, as illustrated in FIG. 10, the shield pattern 350 may be positioned beneath at least a portion of the gate trench 160. In this case, the bottom surface 160_B of the gate trench 160 may be defined by the shield pattern 350 and the epitaxial layer 131.

The shield pattern 350 may include a semiconductor material. For example, the shield pattern 350 may include a first material and a second material different from the first material. Here, the first material may include silicon (Si), and the second material may include carbon (C). The shield pattern 350 may include SiC. As an example, the shield pattern 350 may include 4H-SiC. The shield pattern 350 may have a second conductivity type that is different from the first conductivity type. The shield pattern 350 may be doped with second conductivity type impurities. Here, the second conductivity type may be p-type, but example implementations are not limited thereto. The material, doping type, doping concentration, thickness, etc. of the shield pattern 350 are not limited thereto and may be changed in various ways. The shield pattern 350 may prevent the breakdown voltage of the transistor from being reduced due to an electric field generated by a voltage applied to the gate electrode 150. Accordingly, the reliability of the semiconductor device according to the implementation may be improved.

Referring to FIG. 11, the channel layer 300 of a semiconductor device according to some implementations may be positioned on an inner sidewall 160_S and a bottom surface 160_B of a gate trench 160. For example, the channel layer 300 may include a vertical portion 300_V extending along the inner sidewall 160_S of the gate trench 160 and a horizontal portion 300_H extending along the bottom surface 160_B of the gate trench 160.

The vertical portion 300_V may extend in the third direction (Z direction). The vertical portion 300_V may be positioned between the gate insulating layer 140 and the first conductivity type doped layer 137, between the gate insulating layer 140 and the well region 133, and between the gate insulating layer 140 and the epitaxial layer 131. The vertical portion 300_V may overlap with the first conductivity type doped layer 137, the well region 133, and the epitaxial layer 131 in the first direction (X direction). The vertical portion 300_V may be in contact with the first conductivity type doped layer 137, the well region 133, and the epitaxial layer 131, but example implementations are not limited thereto.

The horizontal portion 300_H may extend in the first direction (X direction). The horizontal portion 300_H may be positioned on a portion of the epitaxial layer 131 constituting the bottom surface 160_B of the gate trench 160. The horizontal portion 300_H may be connected to the vertical portion 300_V. The horizontal portion 300_H may be positioned between the gate insulating layer 140 and the epitaxial layer 131. The horizontal portion 300_H may overlap with the gate electrode 150 in the third direction (Z direction). The thickness of the vertical portion 300_V in the third direction (Z direction) may be greater than or equal to the thickness of the horizontal portion 300_H in the first direction (X direction), but example implementations are not limited thereto. As another example, the thickness of the horizontal portion 300_H along the third direction (Z direction) may be smaller than the thickness of the vertical portion 300_V along the first direction (X direction). The horizontal portion 300_H may be a portion of the channel material layer (see 300P of FIG. 16) positioned on the bottom surface 160_B of the gate trench 160, which is formed when the channel material layer (see 300P of FIG. 16) is not sufficiently etched during the process of forming the channel layer 300 by etching at least a portion of the channel material layer (see 300P of FIG. 16) within the gate trench 160.

Referring to FIG. 12, the epitaxial layer 131 may further include a source trench 400. The source trench 400 may be positioned to have a predetermined depth on the upper surface of the epitaxial layer 131. The source trench 400 may be positioned spaced apart from the gate trench 160. For example, the source trench 400 may be positioned spaced apart from the gate trench 160 in the first direction (X direction). The source trench 400 may be positioned on opposite sides of the gate trench 160 in the first direction (X direction). The source trenches 400 positioned on opposite sides of the gate trench 160 may or may not be connected to each other. The source trench 400 may be formed in a roughly U-shape in cross section, and the drawing illustrates only a portion of the source trench 400 formed in a U-shape. The source trench 400 may include a bottom surface and side walls extending from the bottom surface. The angle of the side walls with respect to the floor of the source trench 400 may be vertical, but example implementations are not limited thereto. The bottom surface of the source trench 400 may be positioned at a lower level than the lower surface of the channel layer 300. The bottom surface of the source trench 400 may be positioned closer to the first surface 110a of the substrate 110 than to the lower surface of the channel layer 300.

In some implementations, the well region 133 may be positioned within the source trench 400, and the second conductivity type doped layer 139 may be positioned on a portion of the well region 133 that is positioned within the source trench 400. Accordingly, the lower surface of the well region 133 may be positioned at a lower level than the lower surface of the channel layer 300. The lower surface of the well region 133 may be positioned closer to the first surface 110a of the substrate 110 than to the lower surface of the channel layer 300.

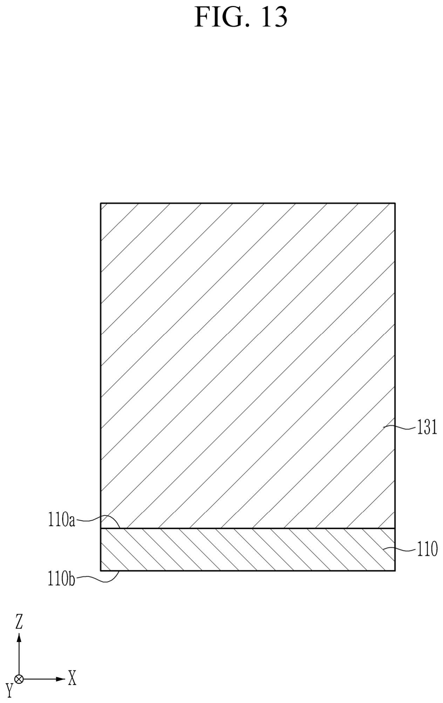

Hereinafter, a method for manufacturing a semiconductor device according to some implementations will be described, referring to FIGS. 13 to 21.

FIGS. 13 to 21 are intermediate process cross-sectional views showing a method for manufacturing a semiconductor device according to some implementations.

Referring to FIG. 13, an epitaxial layer 131 may be formed on the first surface 110a of the substrate 110.

The substrate 110 may be a semiconductor substrate including SiC. For example, substrate 110 may be made of a 4H SiC substrate. In some cases, the substrate 110 may be made of a 3C SiC substrate, a 6H SiC substrate, etc. The substrate 110 may have a first conductivity type. The substrate 110 may be heavily doped as a first conductivity type. The first conductivity type may be n-type, but example implementations are not limited thereto. The resistivity of the substrate 110 may be between about 0.005Ωcm and about 0.035Ωcm. The thickness of the substrate 110 may be from about 10 µm to about 700 µm. The material, doping type, doping concentration, resistivity, thickness, etc. of the substrate 110 are not limited thereto and may be variously changed. The substrate 110 may include a first surface 110a and a second surface 110b opposing each other. The first surface 110a of the substrate 110 may be the upper surface, and the second surface 110b of the substrate 110 may be the lower surface.

An epitaxial layer 131 may be formed on the first surface 110a of the substrate 110. The lower surface of the epitaxial layer 131 may contact the first surface 110a of the substrate 110. However, example implementations are not limited thereto, and other layers may be positioned between the substrate 110 and the epitaxial layer 131. The epitaxial layer 131 may be an epitaxy layer formed from the substrate 110 using an epitaxial growth method.

The epitaxial layer 131 may include a semiconductor material. For example, the epitaxial layer 131 may include a first material and a second material that is different from the first material. Here, the first material may include silicon (Si), and the second material may include carbon (C). The epitaxial layer 131 may include SiC. As an example, the epitaxial layer 131 may include 4H-SiC. The epitaxial layer 131 may include SiC having a 4H hexagonal crystal structure. The epitaxial layer 131 may have the first conductivity type. The epitaxial layer 131 may be doped with first conductivity type impurities. The epitaxial layer 131 may be lightly doped with first conductivity type impurities. Here, the first conductivity type may be n-type, but example implementations are not limited thereto.

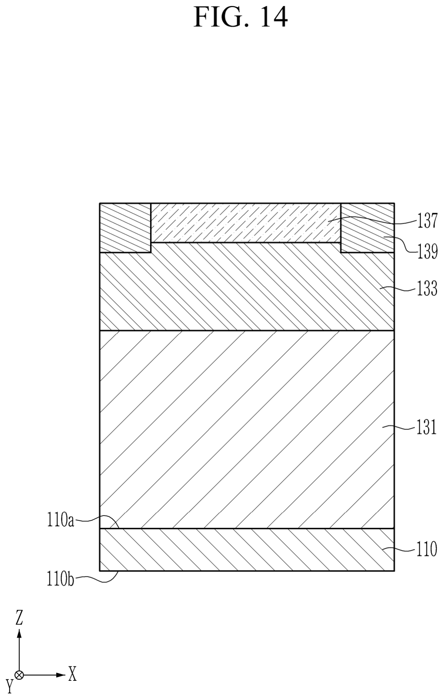

Referring to FIG. 14, the well region 133, the first conductivity type doped layer 137, and the second conductivity type doped layer 139 may be formed within the epitaxial layer 131.

First, an ion implantation process may be performed to form the well region 133 on the upper side of the epitaxial layer 131. The well region 133 may have a predetermined depth along the third direction (Z direction). The well region 133 may include a semiconductor material. For example, the well region 133 may include a first material and a second material that is different from the first material. Here, the first material may include silicon (Si), and the second material may include carbon (C). The well region 133 may include SiC. As an example, the well region 133 may include 4H-SiC. The well region 133 may have a second conductivity type that is different from the first conductivity type. The well region 133 may be doped with a second conductivity type impurity. The well region 133 may be lightly doped with second conductivity type impurities. Here, the second conductivity type may be p-type, but example implementations are not limited thereto.

Next, a first conductivity type doped layer 137 and a second conductivity type doped layer 139 may be formed within the well region 133. An ion implantation process may be performed to form a first conductivity type doped layer 137 and a second conductivity type doped layer 139 on the upper side of the well region 133.

The first conductivity type doped layer 137 and the second conductivity type doped layer 139 may have a predetermined depth along the third direction (Z direction). The first conductivity type doped layer 137 may include a semiconductor material. For example, the first conductivity type doped layer 137 may include a first material and a second material different from the first material. Here, the first material may include silicon (Si), and the second material may include carbon (C). The first conductivity type doped layer 137 may include SiC. As an example, the first conductivity type doped layer 137 may include 4H-SiC. The first conductivity type doped layer 137 may have a first conductivity type. The first conductivity type doped layer 137 may be doped with first conductivity type impurities. The first conductivity type doped layer 137 may be heavily doped with first conductivity type impurities. Here, the first conductivity type may be n-type, but example implementations are not limited thereto.

The second conductivity type doped layer 139 may include a semiconductor material. For example, the second conductivity type doped layer 139 may include a first material and a second material different from the first material. Here, the first material may include silicon (Si), and the second material may include carbon (C). The second conductivity type doped layer 139 may include SiC. As an example, the second conductivity type doped layer 139 may include 4H-SiC. The second conductivity type doped layer 139 may have a second conductivity type. The second conductivity type doped layer 139 may be doped with a second conductivity type impurity. The second conductivity type doped layer 139 may be heavily doped with second conductivity type impurities. Here, the second conductivity type may be p-type, but example implementations are not limited thereto.

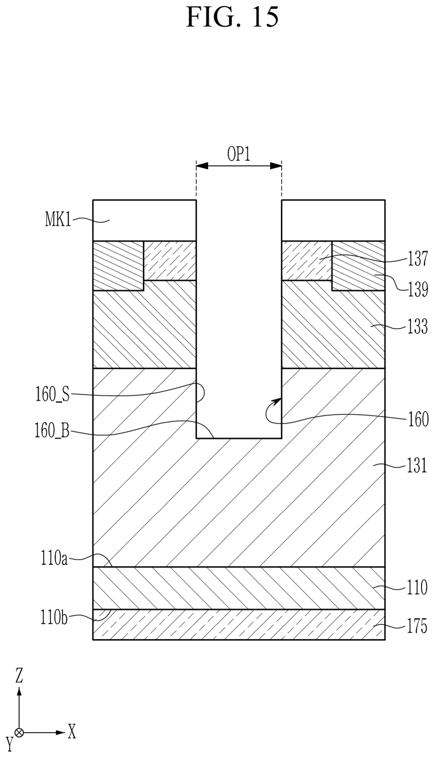

Referring to FIG. 15, the first conductivity type doped layer 137, the well region 133, and the epitaxial layer 131 may be patterned to form a gate trench 160 within the first conductivity type doped layer 137, the well region 133, and the epitaxial layer 131.

For example, a first mask pattern MK1 having a first opening OP1 may be formed on a first conductivity type doped layer 137 and a second conductivity type doped layer 139. The first opening OP1 may expose at least a portion of the first conductivity type doped layer 137. The first mask pattern MK1 may be used as a mask to pattern the first conductivity type doped layer 137, the well region 133, and the epitaxial layer 131 to form a gate trench 160.

The gate trench 160 may be formed to a predetermined depth. The gate trench 160 may be formed in a roughly U-shape in cross section. The gate trench 160 may include a bottom surface 160_B and an inner sidewall 160_S extending from the bottom surface 160_B. The inner sidewall 160_S of the gate trench 160 may be defined by the epitaxial layer 131, the well region 133, and the first conductivity type doped layer 137. The bottom surface 160_B of the gate trench 160 may be defined by the epitaxial layer 131. The angle of the inner sidewall 160_S with respect to the bottom surface 160_B of the gate trench 160 may be vertical, but example implementations are not limited thereto. As another example, as in the implementations of FIG. 6 and FIG. 7, the width of the gate trench 160 in the first direction (X direction) may increase as it moves away from the first surface 110a of the substrate 110. The epitaxial layer 131 may be exposed by gate trench 160. The side surface of the well region 133 and the side surface of the first conductivity type doped layer 137 may be exposed by the gate trench 160.

The depth of the gate trench 160 in the third direction (Z direction) may be greater than the thickness of the well region 133 in the third direction (Z direction). The bottom surface 160_B of the gate trench 160 may be positioned at a lower level than the lower surface of the well region 133. The bottom surface 160_B of the gate trench 160 may be positioned closer to the first surface 110a of the substrate 110 than to the lower surface of the well region 133.

Referring to FIG. 16, after removing the first mask pattern MK1, a channel material layer 300P may be formed within the gate trench 160.

A channel material layer 300P may be formed on the bottom surface 160_B and the inner sidewall 160_S of the gate trench 160. In this case, a channel material layer 300P may be formed together on the upper surface of the first conductivity type doped layer 137 and the upper surface of the second conductivity type doped layer 139. The channel material layer 300P may fill gate trench 160. The channel material layer 300P may be in contact with the epitaxial layer 131, the well region 133, and the first conductivity type doped layer 137.

The channel material layer 300P may include a semiconductor material. The channel material layer 300P may include the same material as the epitaxial layer 131. For example, the channel material layer 300P may include a first material and a second material different from the first material. Here, the first material may include silicon (Si), and the second material may include carbon (C). As an example, the channel material layer 300P may include SiC.

The channel material layer 300P may have a different crystal structure from the epitaxial layer 131. For example, the channel material layer 300P may include 3C-SiC. The channel material layer 300P may include SiC having a 3C cubic crystal structure. In contrast, the epitaxial layer 131 may include 4H-SiC. The epitaxial layer 131 may include SiC having a 4H hexagonal crystal structure. The channel material layer 300P may include a material having a different energy band gap from the epitaxial layer 131. For example, the energy band gap of the material constituting the channel material layer 300P may be smaller than the energy band gap of the material constituting the epitaxial layer 131. The channel material layer 300P includes a material having a lower defect rate than the epitaxial layer 131.

The channel material layer 300P may have the same conductivity type as the epitaxial layer 131. The channel material layer 300P may have first conductivity type. The channel material layer 300P may be doped with first conductivity type impurities. The channel material layer 300P may be lightly doped with first conductivity type impurities. Here, the first conductivity type may be n-type, but example implementations are not limited thereto. The doping concentration of the channel material layer 300P may be lower than the doping concentration of the substrate 110. The doping concentration of the channel material layer 300P may be about 1*10¹⁵cm⁻³ or more and about 1*10¹⁷cm⁻³ or less. The material, doping type, doping concentration, etc. of the channel material layer 300P are not limited thereto and may be changed in various ways.

The channel material layer 300P may be formed using an epitaxial growth method using a portion of the epitaxial layer 131 exposed by the gate trench 160 as a seed. Additionally, the channel material layer 300P may be formed using an epitaxial growth method using a portion of the well region 133 exposed by the gate trench 160 and a portion of the first conductivity type doped layer 137 exposed by the gate trench 160 as seeds. For example, the channel material layer 300P may be formed on a portion of the epitaxial layer 131 defining the bottom surface 160_B of the gate trench 160 and a portion of the epitaxial layer 131 defining the inner sidewall 160_S of the gate trench 160.

In this case, a defect may occur in the channel material layer 300P depending on the crystal plane of the growing channel material layer 300P. For example, a defect may occur in a portion of the channel material layer 300P formed at a point a1 where the bottom surface 160_B of the gate trench 160 and the inner sidewall 160_S meet, a portion of the channel material layer 300P formed at a point a2 where the inner sidewall 160_S of the gate trench 160 and the upper surface of the first conductivity type doped layer 137 meet, a portion of the channel material layer 300P formed on the gate trench 160, and a portion of the channel material layer 300P formed on the bottom surface 160_B of the gate trench 160. However, example implementations are not limited thereto, and the process of forming the channel material layer 300P may be performed using a deposition process.

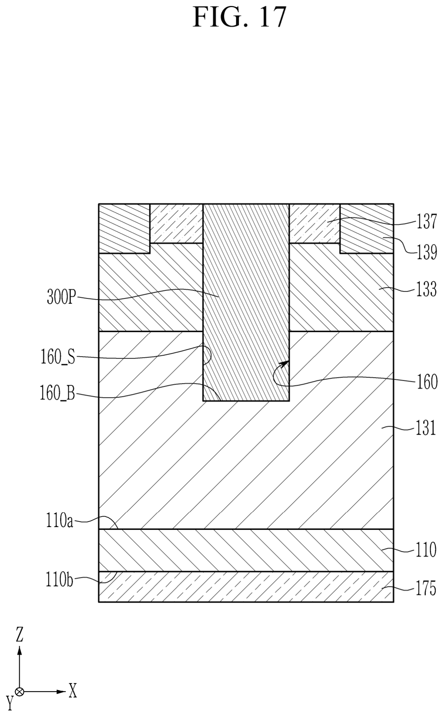

Referring to FIG. 17, at least a portion of the channel material layer 300P positioned on the first conductivity type doped layer 137 and the second conductivity type doped layer 139 may be removed. For example, a planarization process may be performed to remove at least a portion of the channel material layer 300P using chemical mechanical polishing (CMP). Accordingly, the upper surface of the first conductivity type doped layer 137 and the upper surface of the second conductivity type doped layer 139 may be exposed. As at least a portion of the channel material layer 300P is removed, a defect formed in a portion of the channel material layer 300P formed at a point where the inner sidewall 160_S of the gate trench 160 and the upper surface of the first conductivity type doped layer 137 meet (see a2 of FIG. 16) and a defect formed in a portion of the channel material layer 300P formed on the gate trench 160 may be removed.

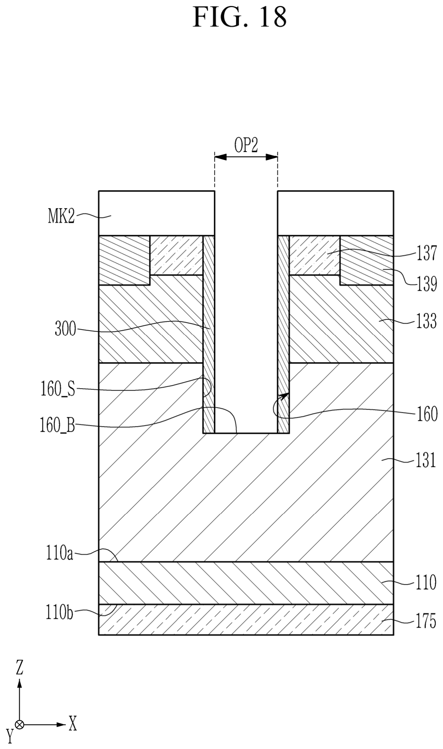

Referring to FIG. 18, at least a portion of the channel material layer 300P may be etched to form a channel layer 300 exposing the bottom surface 160_B of the gate trench 160.

For example, a second mask pattern MK2 having a second opening OP2 may be formed on the first conductivity type doped layer 137 and the second conductivity type doped layer 139. The second opening OP2 may expose at least a portion of the channel material layer 300P positioned within the gate trench 160. The second mask pattern MK2 may be used as a mask to etch at least a portion of the channel material layer 300P to form the channel layer 300. The process of etching at least a portion of the channel material layer 300P may be performed using a dry etching method, but example implementations are not limited thereto. The process of etching the channel material layer 300P may be performed using a material having an etching selectivity with respect to the epitaxial layer 131. As another example, at least a portion of the channel material layer 300P may be etched using a wet etching method. As another example, after etching at least a portion of the channel material layer 300P using a dry etching method, the channel layer 300 may be formed by etching at least a portion of the channel material layer 300P using a wet etching method.

Accordingly, the bottom surface 160_B of the gate trench 160 may be exposed. The channel layer 300 may be positioned on the inner sidewall 160_S of the gate trench 160. Accordingly, the defect formed in the portion of the channel material layer 300P formed on the bottom surface 160_B of the gate trench 160 may be removed, and accordingly, the reliability of the semiconductor device may be improved.

The channel layer 300 may protrude from the lower surface of the well region 133 toward the first surface 110a of the substrate 110. The lower surface 300_B of the channel layer 300 may be positioned at a lower level than the lower surface of the well region 133. The lower surface 300_B of the channel layer 300 may be positioned closer to the first surface 110a of the substrate 110 than to the lower surface of the well region 133. The channel layer 300 may overlap with the well region 133 and the epitaxial layer 131 in the first direction (X direction).

The thickness of the channel layer 300 in the first direction (X direction) may remain substantially constant even as it increases away from the bottom surface 160_B of the gate trench 160, but example implementations are not limited thereto. For example, the thickness of the channel layer 300 in the first direction (X direction) may be about 1/10 to about 1/3 of the gate trench 160, but example implementations are not limited thereto. For example, the thickness of the channel layer 300 in the first direction (X direction) may be approximately 100 nm or more, but example implementations are not limited thereto. As another example, as in the implementation of FIG. 2, the channel layer 300 may include a portion whose thickness increases as it moves away from the bottom surface 160_B of the gate trench 160. The thickness of the channel layer 300 in the first direction (X direction) may increase as it moves away from the bottom surface 160_B of the gate trench 160. As another example, as in the implementation of FIG. 3, the thickness of the channel layer 300 in the first direction (X direction) may decrease as it moves away from the bottom surface 160_B of the gate trench 160.

The channel layer 300 may include a semiconductor material. The channel layer 300 may comprise the same material as epitaxial layer 131. For example, the channel layer 300 may include a first material and a second material different from the first material. Here, the first material may include silicon (Si), and the second material may include carbon (C). For example, the channel layer 300 may include SiC.

The channel layer 300 may have a different crystal structure than the epitaxial layer 131. For example, the channel layer 300 may include 3C-SiC. The channel layer 300 may include SiC having a 3C cubic crystal structure. In contrast, the epitaxial layer 131 may include 4H-SiC. The epitaxial layer 131 may include SiC having a 4H hexagonal crystal structure.

The content (at%) of the first material of the channel layer 300 may be substantially the same as the content (at%) of the first material of the epitaxial layer 131, but example implementations are not limited thereto. Here, the first material may include silicon (Si), and the second material may include carbon (C). The lower surface of the channel layer 300 may be positioned substantially at the same level as the bottom surface 160_B of the gate trench 160. The lower surface of the channel layer 300 and the bottom surface 160_B of the gate trench 160 may be positioned at substantially the same distance from the first surface 110a of the substrate 110. However, example implementations are not limited thereto, and as another example, as in the implementation of FIG. 4, a portion of the channel layer 300 adjacent to the bottom surface 160_B of the gate trench 160 may be etched. In this case, the lower surface of the channel layer 300 may be positioned farther from the first surface 110a of the substrate 110 than the bottom surface 160_B of the gate trench 160. As another example, as in the implementation of FIG. 5, during the process of etching at least a portion of the channel material layer 300P, at least a portion of the epitaxial layer 131 may be etched together.

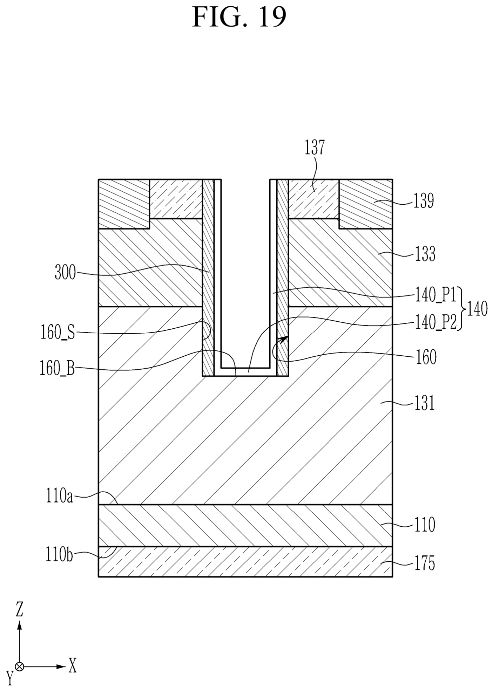

Referring to FIG. 19, a gate insulating layer 140 may be formed on the inner side surface of the channel layer 300 and the bottom surface 160_B of the gate trench 160.

The gate insulating layer 140 may be positioned on the inner side surface of the channel layer 300. The gate insulating layer 140 may be in contact with the channel layer 300. Additionally, the gate insulating layer 140 may be positioned on the bottom surface 160_B of the gate trench 160. The lower surface of the gate insulating layer 140 may be in contact with the epitaxial layer 131. The gate insulating layer 140 may be positioned with a substantially uniform thickness on the bottom surface 160_B of the gate trench 160 and the inner side surface of the channel layer 300, but example implementations are not limited thereto.

The lower surface of the gate insulating layer 140 may be positioned at substantially the same level as the lower surface 300_B of the channel layer 300. The lower surface of the gate insulating layer 140 and the lower surface 300_B of the channel layer 300 may be positioned at substantially the same distance from the first surface 110a of the substrate 110.

According to some implementations, a gate insulating layer 140 of a semiconductor device may include a first portion 140_P1 positioned on an inner side surface of a channel layer 300 and a second portion 140_P2 positioned on a bottom surface 160_B of a gate trench 160.

The first portion 140_P1 may extend in the third direction (Z direction). The first portion 140_P1 may extend parallel to the channel layer 300. The first portion 140_P1 may be positioned between the channel layer 300 and the gate electrode 150. The first portion 140_P1 may contact the inner side surface of the channel layer 300. The upper surface of the first portion 140_P1 may be positioned at substantially the same level as the upper surface of the channel layer 300. The upper surface of the first portion 140_P1 and the upper surface of the channel layer 300 may be positioned at substantially the same distance from the first surface 110a of the substrate 110. Additionally, the upper surface of the first portion 140_P1 may be positioned at substantially the same level as the upper surface of the first conductivity type doped layer 137. The upper surface of the first portion 140_P1 and the upper surface of the first conductivity type doped layer 137 may be positioned at substantially the same distance from the first surface 110a of the substrate 110.

The second portion 140_P2 may be positioned on the bottom surface 160_B of the gate trench 160. The second portion 140_P2 may be conformally positioned on the bottom surface 160_B of the gate trench 160. The second portion 140_P2 may extend in the first direction (X direction). The second portion 140_P2 may be connected to the first portion 140_P1. The second portion 140_P2 may refer to a portion of the gate insulating layer 140 positioned on the bottom surface 160_B of the gate trench 160. The thickness of the second portion 140_P2 along the third direction (Z direction) may be substantially the same as the thickness of the first portion 140_P1 along the first direction (X direction), but example implementations are not limited thereto. As another example, as in the implementation of FIG. 8, the thickness of the second portion 140_P2 along the third direction (Z direction) may be greater than the thickness of the first portion 140_P1 along the first direction (X direction).

The gate insulating layer 140 may include an insulating material. For example, the gate insulating layer 140 may include silicon oxide (SiO₂). However, example implementations are not limited thereto, and the material of the gate insulating layer 140 may be changed in various ways. As another example, the gate insulating layer 140 may include SiN, SiON, SiC, SiCN or a combination thereof. In some implementations, the gate insulating layer 140 may further include certain elements. For example, the gate insulating layer 140 may include carbon (C), nitrogen (N), or a combination thereof. For example, the gate insulating layer 140 may be composed of silicon oxide (SiO₂) containing carbon (C) and nitrogen (N). The gate insulating layer 140 may be formed of a single layer or multiple layers.

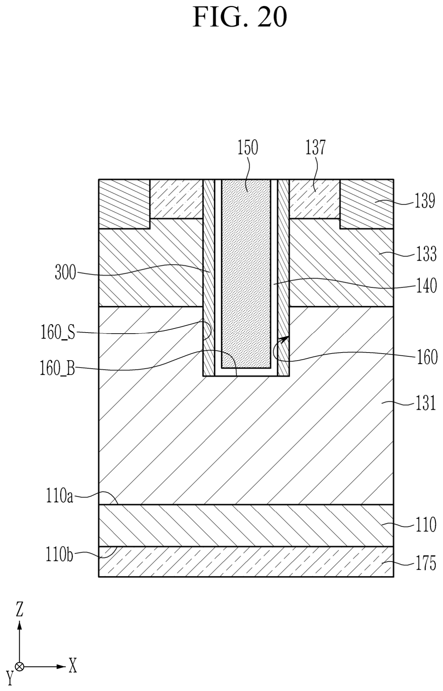

Referring to FIG. 20, a gate electrode 150 may be formed within a gate trench 160. The gate electrode 150 may fill the remaining gate trench 160 portion after the channel layer 300 and the gate insulating layer 140 are formed. The gate electrode 150 may include a conductive material. For example, the gate electrode 150 may include polysilicon doped with impurities. As another example, the gate electrode 150 may include a metal, a metal alloy, a conductive metal nitride, a metal silicide, a doped semiconductor material, a conductive metal oxide, a conductive metal nitride, or a combination thereof. The gate electrode 150 may be formed of a single layer or multiple layers.

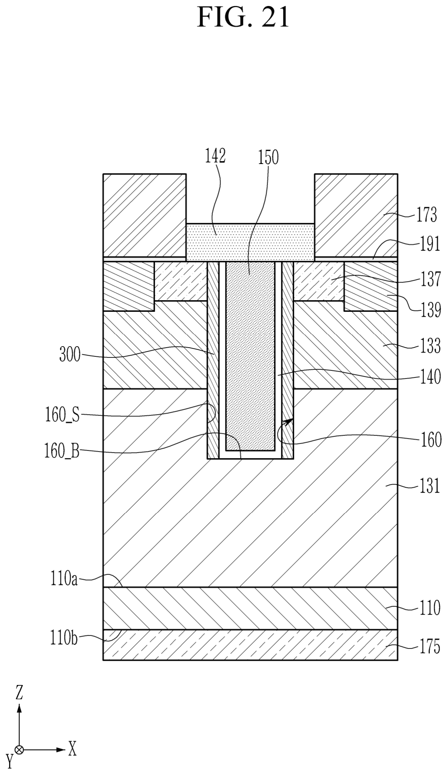

Referring to FIG. 21, a capping layer 142 is formed on a gate electrode 150, a gate insulating layer 140, and a channel layer 300, a source electrode 173 is formed on a first conductivity type doped layer 137 and a second conductivity type doped layer 139, and a drain electrode 175 is formed on a second surface 110b of a substrate 110, thereby forming a semiconductor device according to some implementations.

The source electrode 173 may include a conductive material. For example, the source electrode 173 may include a metal, a metal alloy, a conductive metal nitride, a metal silicide, a doped semiconductor material, a conductive metal oxide, or a conductive metal nitride. In the process of forming the source electrode 173, the metal silicide layer 191 may be formed on the first conductivity type doped layer 137 and the second conductivity type doped layer 139, and then the source electrode 173 may be formed on the metal silicide layer 191, but example implementations are not limited thereto.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

The above detailed description of the implementations of the present disclosure is not intended to limit the scope of the present disclosure. Rather, various modifications and improvements made by a person of ordinary skill in the art using the basic concepts of the present disclosure as defined in the following claims also fall within the scope of the present disclosure.

## Claims

1. A semiconductor device comprising:
a substrate (110) comprising a first surface (110a)and a second surface (110b) that is on an opposite side of the substrate (110) from the first surface (110a);
an epitaxial layer (131) on the first surface (110a) of the substrate (110), the epitaxial layer (131) comprising a gate trench (160), wherein the epitaxial layer (131) has a first conductivity type;
a channel layer (300) on an inner sidewall (160_s) of the gate trench (160), wherein the channel layer (300) has the first conductivity type and has a lower defect rate than that of the epitaxial layer (131);
a gate electrode (150) in the gate trench (160);
a gate insulating layer (140) on a bottom surface of the gate trench (160), and between the channel layer (300) and the gate electrode (150);
a source electrode (173) on the epitaxial layer (131); and
a drain electrode (175) on the second surface (110b) of the substrate (110).

2. The semiconductor device of claim 1, wherein the channel layer (300) includes a same material as the epitaxial layer (131).

3. The semiconductor device of claim 1 or 2, wherein the channel layer (300) has a different crystal structure from the epitaxial layer (131).

4. The semiconductor device of claim 1, 2 or 3, wherein the channel layer (300) comprises a first material and a second material different from the first material, and wherein the first material includes Si and the second material includes C.

5. The semiconductor device of any one of claims 1 to 4, wherein a lower surface of the gate insulating layer (140) is in contact with the epitaxial layer (131), wherein the lower surface of the gate insulating layer (140) faces the first surface (110a) of the substrate (110).

6. The semiconductor device of claim 5, wherein a lower surface (300_B) of the channel layer (300) is farther from the first surface (110a) of the substrate (110) than the lower surface of the gate insulating layer (140), and wherein the lower surface (300_B) of the channel layer (300) faces the first surface (110a) of the substrate (110).

7. The semiconductor device of any one of claims 1 to 6, wherein the gate insulating layer (140) comprises, a first portion (140_P1) on an inner side surface of the channel layer (300), and a second portion (140_P2) on the bottom surface (160_B) of the gate trench (160), wherein a thickness of the second portion (140_P2) is greater than or equal to a thickness of the first portion (140_P1).

8. The semiconductor device of any one of claims 1 to 7, wherein the channel layer (300) extends in a first direction (Z), and the gate electrode (150) does not overlap with the channel layer (300) in the first direction (Z).

9. The semiconductor device of any one of claims 1 to 8, wherein a thickness of the channel layer (300) is 1/10 to 1/3 of a width of the gate trench (160).

10. The semiconductor device of any one of claims 1 to 9, wherein the channel layer (300) comprises a portion whose thickness increases with an increase in a distance from the bottom surface of the gate trench (160).

11. The semiconductor device of any one of claims 1 to 10, comprising, a shield pattern (350) between the epitaxial layer (131) and the gate insulating layer (140), the shield pattern (350) having a second conductivity type different from the first conductivity type.

12. The semiconductor device of claim 11, wherein the shield pattern (350) is between the channel layer (300) and the epitaxial layer (131).

13. The semiconductor device of any one of claims 1 to 12, the channel layer (300) comprising, a vertical portion (300_V) that extends in a first direction (Z) along the inner sidewall (160_s) of the gate trench (160), and a horizontal portion (300_H) that extends in a second direction (X) that intersects the first direction (Z) along the bottom surface (160_B) of the gate trench (160).

14. The semiconductor device of claim 13, wherein a thickness of the vertical portion (300_V) in the second direction (X) is greater than or equal to a thickness of the horizontal portion (300_H) in the first direction (Z).

15. The semiconductor device of any one of claims 1 to 14, wherein the gate insulating layer (140) protrudes from a lower surface (300_B) of the channel layer (300) toward the first surface (110a) of the substrate (110).
